# FASCICULE DE BREVET EUROPEEN

(11) **EP 0 490 738 B1**
(45) Date de publication et mention de la délivrance du brevet: **24.01.1996**
(21) Numéro de dépôt: 91403306.3
(22) Date de dépôt: 06.12.1991
(51) Int. Cl.: G06F 11/26

(54) **Circuit intégré avec contrôleur de test périphérique**
Integrierter Schaltkreis mit Peripherieprüfungssteuerung
Integrated circuit with peripheral test controller

(30) Priorité: 07.12.1990 FR 9015348
(43) Date de publication de la demande: 17.06.1992
(73) Titulaire: THOMSON-CSF SEMICONDUCTEURS SPECIFIQUES, F-75008 Paris (FR)
(72) Inventeur: Lestrat, Patrick, F-92045 Paris la Défense (FR); Leveugle, Régis, F-92045 Paris la Défense (FR)
(74) Mandataire: Guérin, Michel

(56) Documents cités:
- 1989 INTERNATIONAL TEST CONFERENCE PROCEEDINGS Août 1989, WASHINGTON, US pages 55 - 62; A.T. DAHBURA ET AL.: 'An optimal test sequence for the JTAG/IEEE P1149.1 test access port controller.'
- 1989 IEEE INTERNATIONAL CONFERENCE ON COMPUTER DESIGN: VLSI IN COMPUTERS & PROCESSORS Octobre 1989, CAMBRIDGE, US pages 580 - 584; Y. ZORIAN ET AL.: 'Designing fault-tolerant, testable, VLSI processors using the IEEE P1149.1 boundary-scan architecture.'

## Description

L'invention concerne les circuits intégrés, et plus particulièrement les circuits complexes qui nécessitent des moyens de test spécifiques implantés dans le circuit intégré lui-même.

Pour que les utilisateurs du circuit intégré puissent tester le fonctionnement d'une carte ou d'un module hybride incorporant plusieurs circuits intégrés interconnectés entre eux de manière inamovible, on a imaginé des systèmes de test implantés en partie dans les circuits intégrés eux-mêmes et capables de coopérer avec des systèmes analogues inclus dans les autres circuits intégrés de la carte.

Des normes ont été établies dans ce sens, notamment la norme IEEE 1149.1, qui définit des moyens de test à incorporer aux circuits intégrés pour que le test d'une carte soit possible à partir de broches de connexion de la carte sans démontage des composants.

Dans cette norme, les circuits intégrés incorporent chacun un circuit de test interne qui comprend notamment :
- des plots d'entrée-sortie réservés au test;
- un registre d'instructions qui contiendra des instructions de test; les instructions sont introduites par les plots réservés au test,
- une logique de décodage de ces instructions,
- des registres à décalage à entrées à la fois parallèle et série, servant principalement à contenir des données de test provenant soit de l'extérieur (pour forcer des états logiques désirés sur certains noeuds) soit de l'intérieur du circuit intégré (pour observer l'état de certains noeuds),
- une circuiterie de commande des opérations de test, contrôlée par les plots réservés au test; cette circuiterie commande directement le registre d'instructions et indirectement (en fonction des instructions du registre d'instructions) les autres registres, les multiplexeurs, et d'autres éléments nécessaires au test.

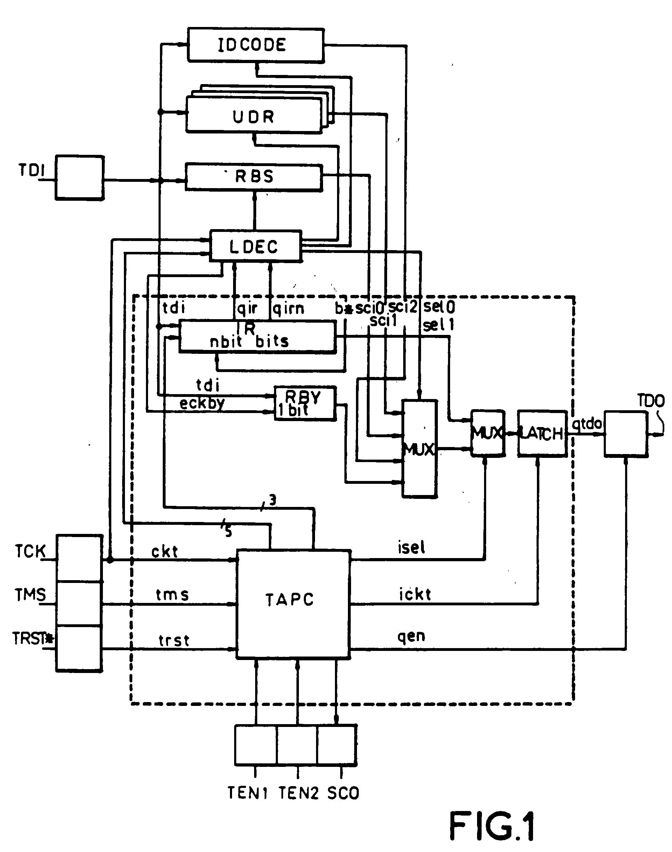

La figure 1 représente un exemple d'architecture d'un circuit de test pouvant exécuter des tests en conformité avec la norme citée précédemment.

L'enseignement du document "1989 IEEE INTERNATIONAL CONFERENCE ON COMPUTER DESIGN: VLSI IN COMPUTERS AND PROCESSORS, Octobre 1989, Cambridge, US, pp.580-584, Y. Zorian et al., intitulé: Designing fault-tolerant, testable, VLSI processors using the IEEE P1149.1 boundary scan architecture", correspond substantiellement à l'état de la technique décrit par la figure 1 de la présente demande. D1 décrit additionnellement la structure d'une cellule SCCO comportant une combinaison de multiplexeurs et de latchs afin de permettre la contrôlabilité et l'observabilité du signal traversant ladite cellule en fonction de signaux de contrôles fournis par le contrôleur TAP. Toutefois, D1 ne donne aucune indication quant à la contrôlabilité et l'observabilité desdits signaux de contrôles.

On reviendra plus loin sur la description de cette architecture.

Les tests qu'on peut réaliser avec un tel circuit sont très complexes; ils consistent à générer de nombreuses séquences de vecteurs de test qu'on introduit dans le circuit intégré par un des plots de test, et à recevoir du circuit des vecteurs de données de test, également par un des plots de test. Les tests sont effectués soit sur le circuit intégré seul (test par le fabricant par exemple) soit sur le circuit intégré dans son environnement (test du circuit présent sur une carte et indissociable de cette carte).

Un des problèmes rencontrés dans les procédures de test est le fait que les résultats du test ne sont fiables que si les circuits interne de test eux-mêmes sont fonctionnellement bons.

Or le test d'un circuit est très long et il est tout-à-fait possible de consommer inutilement un long temps de test pour s'apercevoir à la fin que le circuit de test lui-même était défectueux.

On rappelle à ce sujet que les procédures de test constituent un paramètre très important du coût de fabrication d'un circuit intégré complexe : les circuits doivent être testés chacun individuellement et chacun de manière très approfondie. Le temps consommé en test dans la chaîne de fabrication est très considérable.

Il y a évidemment des difficultés à tester le circuit de test lui-même : il faudrait commander ce test par un autre circuit de test; et il faudrait donc d'autres plots d'entrée, d'autres registres, d'autres circuits de commande, etc.

On pourrait aussi prévoir des tests fonctionnels supplémentaires du circuit intégré, qui feraient apparaître indirectement les défauts du circuit de test. Mais cela augmente considérablement les longueurs et nombres de séquences de test, d'où il résulte des coûts importants, notamment lorsqu'il y a beaucoup d'instructions de test possibles : il faut prévoir la vérification dans chaque cas possible.

On propose selon l'invention telle que revendiquée dans la revendication 1 une solution particulièrement simple pour mettre en évidence l'essentiel des défauts pouvant provenir du circuit de test lui-même.

L'invention s'applique essentiellement dans le cas d'un circuit intégré qui comprend une circuiterie nécessaire au test du circuit, avec un contrôleur comportant :
- une machine à états finis (c'est-à-dire un registre d'états dont les sorties parallèles sont rebouclées sur les entrées parallèles à travers une logique combinatoire qui peut également recevoir des signaux de commande extérieurs);
- des multiplexeurs associés aux cellules du registre d'états pour permettre soit un fonctionnement sériel soit un fonctionnement parallèle de ce registre d'états;
- et un étage de génération de signaux de contrôle, connecté en sortie du registre pour fournir des signaux de contrôle des autres éléments (registres, multiplexeurs, bascules de verrouillage, etc. notamment) de la circuiterie de test, en fonction de l'état défini par le registre d'états.

Selon l'invention, on propose que les multiplexeurs placés entre la logique combinatoire et les cellules du registre d'états soient pourvus d'entrées supplémentaires permettant de stocker dans ces cellules, en vue de les transmettre ultérieurement pour observation, l'état d'au moins certains des signaux de contrôle.

Ainsi, il devient possible non seulement de tester les états du registre d'état (pour vérifier que la machine à états finis prend bien tous les états qu'elle doit prendre) mais aussi de tester les signaux de contrôle émis par le contrôleur, pour vérifier que les signaux de contrôle émis sont bien les signaux désirés. On détecte ainsi plus vite des défauts éventuels de la circuiterie de test elle-même.

Le contenu du registre d'états est vidé périodiquement (en mode série) lorsqu'on veut tester son contenu. Si on veut tester les signaux de contrôle issus du contrôleur, on commence donc par charger dans le registre d'état les signaux de contrôle, puis on évacue vers une sortie du circuit intégré, en vue de l'analyser, le contenu du registre.

Ce procédé ne résout évidemment pas tous les problèmes de test (il y aura toujours des dysfonctionnements possibles à l'intérieur du circuit de test sans que le circuit de test arrive à les détecter), mais l'invention permet de tester directement un des éléments les plus stratégiques du fonctionnement du circuit de test qui est l'élaboration des signaux de contrôle du test.

De préférence, lorsque la circuiterie de test comprend un registre d'instructions (c'est le cas général), suivi d'une logique de décodage des instructions contenues dans le registre, le registre étant associé à des multiplexeurs d'entrée permettant de faire fonctionner le registre à volonté en série ou en parallèle, on prévoit également que les multiplexeurs comportent des entrées supplémentaires permettant de stocker dans le registre des signaux logiques prélevés sur les sorties verrouillées du registre d'instructions. La sortie du registre d'instructions est en effet un autre point assez stratégique et que le fabricant du circuit intégré devrait pouvoir tester lui-même directement. L'invention permet alors au fabricant du circuit d'affirmer avec certitude que la logique de décodage (conçue par le client) reçoit bien les instructions désirées lorsque de telles instructions sont introduites dans le registre.

Il faut comprendre qu'une des grandes difficultés de la conception de ces circuits de tests est le fait que les circuits intégrés sont conçus au moins partiellement par le client du circuit, mais à partir de bases de conception fournies par le fabricant; il faut donc que les bases de conception des circuits de test, conçues par le fabricant, soient suffisamment universelles pour fonctionner alors qu'on ne connaît pas encore l'utilisation qui en sera faite par le client-concepteur dans un circuit intégré qu'on ne connaît pas non plus.

Un avantage important de l'invention réside dans la plus grande facilité d'obtenir un test fiable indépendamment de l'application concrète du client.

D'autres caractéristiques et avantages de l'invention apparaîtront à la lecture de la description détaillée qui suit et qui est faite en référence aux dessins annexés dans lesquels :
- la figure 1 représente une architecture de circuiterie de test dans laquelle la présente invention peut avantageusement être incorporée;
- la figure 2 représente le contrôleur principal de la circuiterie de test ;
- la figure 3 représente le registre d'instructions modifié dans une réalisation particulière de l'invention.

Sur la figure 1, on a représenté une circuiterie de test permettant d'établir des tests dits "périphériques" selon la norme IEEE 1149.1.

Dans cette norme, les circuits intégrés incorporent une circuiterie de test comprenant notamment un registre à décalage RBS à entrées et sorties à la fois série et parallèles; ce registre est relié aux plots d'entrée-sortie du circuit intégré pour pouvoir soit observer ce qui se passe sur ces plots soit forcer ces plots à des valeurs déterminées au cours d'une étape de test. Les plots ne sont pas représentés. Ce registre RBS est appelé "registre de boundary scan" ou "registre de test périphérique".

Le registre RBS comporte une cellule associée à chaque plot d'entrée-sortie. Lorsqu'il fonctionne en mode de chargement parallèle on peut charger dans le registre les états présents sur les plots; puis on peut faire fonctionner le registre en mode de déchargement série (registre à décalage) pour transférer ces états vers l'extérieur du circuit intégré en vue de l'observation du comportement du circuit; ou alors, en mode de chargement série, on peut amener de l'extérieur une séquence d'états logiques dans le registre, après quoi on passe en mode de déchargement parallèle de ces états sur les différents plots pour forcer des états désirés sur ces plots au cours d'une étape de test.

Le circuit intégré comporte un plot d'entrée série (TDI) par lequel on peut introduire des données en série dans le registre RBS lorsqu'il fonctionne en registre à décalage. Il comporte aussi un plot de sortie série (TDO) pour évacuer les données en série du registre lors du décalage. Le mot "plot" employé dans cette description désigne l'ensemble d'un plot de contact conducteur et du circuit d'interface qui lui est obligatoirement associé (interface d'entrée ou sortie ou bidirectionnel ou trois états selon les cas).

Dans l'organisation d'une carte comportant plusieurs circuits intégrés de ce type, les différents circuits intégrés de la carte ou du module à tester sont reliés en chaîne série par leurs entrées TDI et TDO : l'entrée TDI d'un circuit est reliée à la sortie TDO d'un autre. De cette manière, lorsque le registre fonctionne en décalage, d'une part toutes les cellules du registre RBS d'un circuit intégré forment un registre à décalage, et d'autre part les registres RBS de plusieurs circuits intégrés de la carte peuvent être reliés en série pour constituer un vaste registre à décalage entre une broche d'entrée et une broche de sortie de la carte.

Par la broche d'entrée de la carte on peut introduire un vecteur d'instructions ou de données, c'est-à-dire une succession d'états logiques qu'on veut appliquer aux différents circuits intégrés, ces états logiques définissant pour chaque circuit soit une instruction de test particulière à exécuter, soit des données de test à traiter selon l'instruction donnée auparavant. Les tests portent soit sur le fonctionnement interne des circuits intégrés soit sur les interconnexions entre circuits.

Par la broche de sortie de la carte, on recueille un vecteur de données résultant du test. Ces données représentent des états logiques de plots d'entrée/sortie des différents circuits intégrés à la suite de l'exécution d'une instruction de test déterminée.

Il n'y a pas que les plots d'entrée-sortie qui peuvent être ainsi testés par l'intermédiaire de registres à décalage à entrées à la fois parallèles et série. Tout noeud logique du circuit peut être testé. C'est pourquoi on prévoit en général qu'il y a aussi des registres de test spécifiques, qu'on peut appeler registres définis par l'utilisateur, désignés sur la figure par la référence UDR. Ces registres fonctionnent comme le registre RBS sauf que leurs cellules sont connectées, pour observation et forçage, à d'autres noeuds de circuit (non représentés) que les plots d'entrée-sortie. Les registres UDR ont chacun une entrée série reliée au plot d'entrée TDI et une sortie série reliée (indirectement) au plot de sortie TDO; bien entendu un seul registre à la fois peut fonctionner en mode de décalage, sinon il y aurait collision de données sur les plots TDI ou TDO. Des multiplexeurs sont donc en principe interposés entre les sorties série des registres et le plot TDO pour définir quel est le registre relié à un moment donné à la borne TDO. Ce sont les instructions de test qui définissent quel est ou quels sont les registres qui doivent fonctionner pendant une opération et dans quel mode de fonctionnement ils doivent travailler.

C'est pourquoi il est prévu un registre d'instructions, IR, pouvant être chargé en série par l'intermédiaire de la borne TDI, et ayant des entrées parallèles pour recevoir un contenu chargé en mode parallèle. Ce registre est lui-même connecté par sa sortie série à la borne TDO (à travers un multiplexeur), de manière que ce registre puisse faire partie d'un vaste registre à décalage reliant en cascade plusieurs circuits intégrés sur une carte.

Les sorties du registre IR définissent une instruction à n bits. Ces instructions sont transmises à une logique de décodage LDEC qui contrôle directement la sélection et le fonctionnement des registres RBS et UDR et éventuellement des multiplexeurs interposés entre ces registres et le plot TDO.

La logique de décodage reçoit à cet effet non seulement les instructions contenues dans le registre mais également des signaux de contrôle indépendants des instructions et provenant d'un contrôleur TAPC qui est l'organe de contrôle principal de la circuiterie de test et qui sera décrit plus loin.

Les sorties du registre d'instructions sont bien entendu verrouillées, au moins pendant l'exécution d'une étape de chargement série du registre, pour que la logique de décodage ne réagisse pas n'importe comment pendant ce chargement. D'autre part, contrairement aux autres registres de test, le registre d'instructions n'est pas commandé lui-même par la logique de décodage LDEC, mais il est commandé directement par le contrôleur TAPC.

D'autres registres à fonctions plus spécifiques peuvent par ailleurs être prévus. Ils sont également commandés par la logique de décodage LDEC. Dans l'exemple représenté, il y a un registre RBY, à un bit, ayant lui aussi une entrée série connectée au plot TDI et une sortie série connectée au plot TDO (par l'intermédiaire des multiplexeurs). Il sert à court circuiter les autres registres si on le désire : c'est le cas par exemple lorsqu'un vaste registre à décalage est établi entre les entrées TDI et TDO de plusieurs circuits intégrés d'une même carte et lorsqu'on veut que ce registre à décalage ne passe pas à travers les registres RBS ou UDR ou IR, etc. du circuit intégré considéré.

D'autres registres peuvent également être prévus, tel qu'un registre IDCODE d'identification de fabricant ou d'utilisateur, sur le même principe que les autres registres de test.

Le contrôleur TAPC de la circuiterie possède les fonctions globales suivantes :
- il fournit des signaux de contrôle direct du registre d'instructions IR pour sélectionner celui-ci et définir son mode de fonctionnement; il fournit des signaux de contrôle à la logique de décodage d'instructions LDEC pour contrôler indirectement les autres registres en fonction des instructions qui ont été placées dans le registre d'instructions IR; il peut fournir aussi des signaux de commande de certains multiplexeurs, et éventuellement de bascules de verrouillage, et une commande de direction ou une commande de troisième état du plot de sortie TDO s'il y a lieu;
- et pour fournir ces signaux, le contrôleur TAPC est essentiellement constitué par une machine à états finis recevant des signaux extérieurs de quelques plots spécifiques de test qui sont ici un plot TCK, un plot TMS, et un plot TRST.

Le plot TCK est tout simplement destiné à recevoir des signaux d'horloge externe permettant de synchroniser les opérations de test sur plusieurs circuits intégrés simultanément puisque ces circuits doivent pouvoir à un moment donné se comporter comme un vaste registre à décalage.

L'horloge ckt reçue du plot TCK peut d'ailleurs, comme cela est représenté, être appliquée directement aussi à la logique de décodage d'instructions LDEC ou à d'autres éléments de circuit, notamment aux registres qui ont besoin d'un signal d'horloge pour fonctionner.

Le plot TMS permet, lorsque son état change (état échantillonné par exemple sur le front montant de l'horloge ckt), de faire avancer d'un pas le cycle de test en cours défini par le contrôleur TAPC.

Le plot TRST, lorsqu'il est présent, permet de recevoir et transmettre au contrôleur TAPC une commande asynchrone de réinitialisation de la logique de test.

Enfin, on a représenté sur la figure 1 trois plots d'entrée sortie extérieurs supplémentaires qui peuvent servir plus spécifiquement pour la mise en oeuvre de l'invention et qui ont alors les rôles suivants :
- le plot TEN1 et le plot TEN2 servent à transmettre des ordres pour effectuer des tests de la circuiterie de test elle-même (c'est-à-dire un test des signaux de contrôle émis par le contrôleur TAPC, et de préférence aussi un test des sorties parallèles verrouillées du registre d'instructions IR).
- le plot SCO sert à transmettre à l'extérieur les résultats des tests effectués à l'intérieur même de la circuiterie de test.

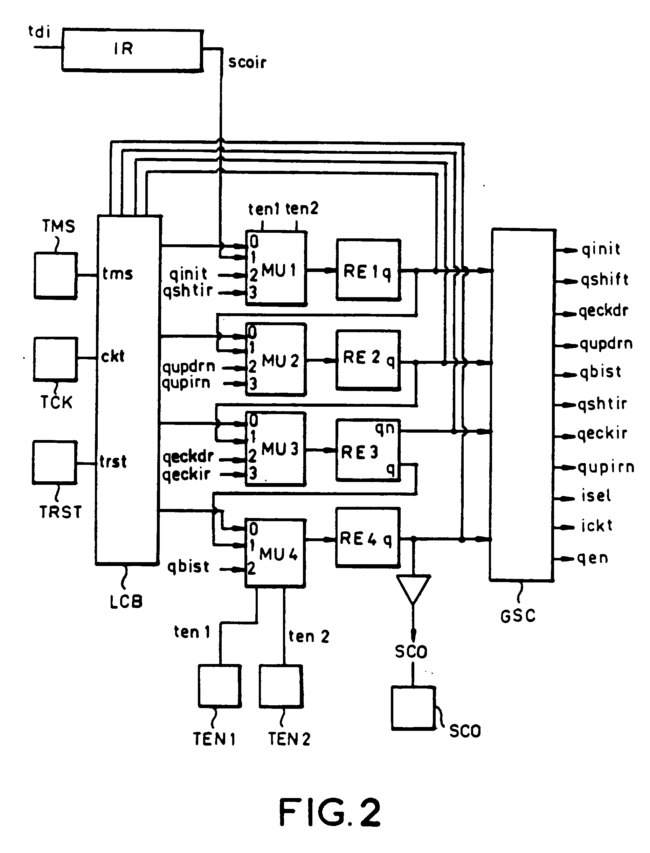

On va maintenant décrire plus en détail, en référence à la figure 2, la structure du contrôleur TAPC, et les circuits de test selon l'invention qui permettent de vérifier très efficacement le bon fonctionnement de ce contrôleur.

Le contrôleur TAPC comporte principalement :
- une machine à états finis dont les changements d'états sont définis par le signal tms présent sur le plot TMS, par exemple échantillonné sur le front montant de l'horloge ckt issue du plot TCK; une machine à états finis est un séquenceur susceptible de prendre un nombre d'états limités (par exemple 16) en fonction de la combinaison de l'état précédent et des ordres extérieurs donnés (ici seuls les changements d'état des plots TMS et TRST définissent de tels ordres extérieurs); l'état de la machine à états finis est défini par le contenu des cellules RE1 à RE4 d'un registre d'état, par exemple 4 cellules binaires pour un maximum de 16 états.
- un étage de génération de signaux de contrôle qui, à partir des signaux d'état définis par le registre d'état de la machine à états finis, fournit les signaux de contrôle servant à commander la circuiterie de test; cet étage constitue la sortie du contrôleur TAPC.

La logique combinatoire recevant les sorties du registre d'état et les signaux tms, ckt, et trst venant des plots de commande de test TMS, TCK, et TRST, est désignée par LCB; c'est cette logique qui définit totalement les différentes séquences possibles de changements d'état.

La sortie de cette logique combinatoire LCB fournit les nouveaux états logiques que doivent prendre les cellules RE1 à RE4 du registre d'état en fonction de l'état précédent et des ordres extérieurs de changement donnés. Mais les sorties de la logique LCB ne sont pas appliquées directement aux cellules RE1 à RE4. Elles sont appliquées par l'intermédiaire de multiplexeurs MU1 à MU4 dont les fonctions seront explicitées ci-après. En fonctionnement normal de test du circuit intégré, les multiplexeurs laissent tout simplement passer vers les cellules RE1 à RE4 les niveaux logiques fournis par la logique combinatoire LCB. Ce n'est que pour tester l'intérieur de la circuiterie de test elle-même que ces multiplexeurs jouent un rôle différent.

L'étage de génération de signaux de contrôle, désigné par la référence GSC, constitue l'étage de sortie du contrôleur TAPC; c'est une fonction logique de décodage recevant les sorties du registre d'état et fournissant divers signaux de contrôle à destination de tous les registres, multiplexeurs, et autres éléments de la circuiterie de test, lorsque de tels éléments doivent être commandés en fonction de l'étape de test en cours.

Dans l'exemple de réalisation plus précisément décrit ici, l'étage de génération de signaux de contrôle fournit les signaux de contrôle suivant :
a) signal de réinitialisation de test :
   - qinit : signal constituant un drapeau de réinitialisation, à destination de tous les registres de test (RBS, UDR notamment) et du registre d'instruction (IR);
b) signaux de contrôle à destination de la logique de décodage d'instructions LDEC :
   - qshif : ordre de décalage des registres de test (plus précisément bien sûr de celui qui est sélectionné par la logique de décodage d'instructions LDEC);
   - qeckdr : validation d'horloge globale des registres de test (RBS, UDR notamment);
   - qupdrn : validation d'horloge globale de bascules de verrouillage en sortie des registres de test,
   - qbist : drapeau indiquant un état spécifique du contrôleur TAPC;
c) signaux de contrôle à destination directe du registre d'instructions IR sans passer par la logique de décodage d'instructions :
   - qshtir :ordre de décalage;
   - qeckir : validation globale d'horloge du registre
   - qupirn : validation globale d'horloge pour les bascules de verrouillage en sortie du registre d'instructions.
d) signaux divers :
   - isel : signal de commande d'un multiplexeur inséré entre la sortie série du registre d'instructions et la sortie TDO (cf. figure 1) de manière que le contenu du registre d'instructions puisse sortir sur la borne TDO;
   - ickt : commande de verrouillage par une bascule interposée en amont du plot TDO;
   - qen : commande de mise en haute impédance de l'interface de sortie du plot TDO.

Certains de ces signaux de contrôle sont très importants et leur mauvais fonctionnement n'est pas facile à détecter indirectement par les tests effectués à travers les registres de test RBS, UDR, etc, alors que c'est plus facile pour d'autres signaux.

C'est pourquoi on a prévu selon l'invention d'abord la particularité suivante : les signaux de contrôle les plus importants issus de l'étage GSC peuvent être mis en mémoire dans les bascules RE1 à RE4 du registre d'état; et ils peuvent être ensuite transmis à l'extérieur pour observation.

Pour cela, les multiplexeurs MU1 à MU4 placés en amont des cellules du registre d'état possèdent des entrées recevant des sorties de l'étage GSC, et ces multiplexeurs sont commandés par des signaux (ten1 et ten2) qui ne sont pas issus de l'étage GSC.

Dans l'exemple représenté (mais ce n'est pas obligatoire), les multiplexeurs sont commandés par des signaux en provenance de plots extérieurs. Selon le nombre d'entrées des multiplexeurs, on prévoit plus ou moins de signaux de commande.

Dans l'exemple représenté, on dispose de quatre cellules d'état RE1 à RE4; on peut donc stocker quatre informations différentes en provenance de l'étage GSC. Toutefois, si on considère qu'un plus grand nombre de signaux de contrôle sont intéressants à tester, on peut prévoir que chaque multiplexeur possède des entrées supplémentaires. On peut analyser alors huit signaux, mais quatre à la fois seulement. C'est ce cas qui est représenté à la figure 2 et il nécessite au moins deux signaux de commande distincts (ten1 et ten2).

Dans l'exemple représenté, ces signaux sont issus de plots extérieurs TEN1 et TEN2 (bien que ce ne soit pas obligatoire) et :
- le premier multiplexeur MU1 possède quatre entrées : entrée normale pour stocker dans la cellule RE1 l'état défini par la logique combinatoire de la machine à états finis; entrée de fonctionnement du registre d'état en mode série; entrée recevant le signal qinit, en vue de le stocker pour l'observer ensuite; entrée recevant le signal qshtir, dans le même but.
- les autres multiplexeurs peuvent avoir aussi quatre entrées, dont une entrée normale de fonctionnement du registre en chargement parallèle, une entrée de fonctionnement série recevant la sortie de la cellule précédente, et deux entrées recevant deux signaux de contrôle différents à tester.

Les cellules du registre sont connectées en cascade pour un fonctionnement en registre à décalage lorsque les signaux ten1 et ten2 commandent la sélection de la deuxième entrée des multiplexeurs. La troisième entrée sert à introduire dans le registre la valeur des signaux qinit, qupdrn, qeckdr, et qbist. La quatrième entrée sert à introduire trois autres signaux de logique dont il est intéressant de vérifier l'état : qshtir, qupirn, qeckir. Ces choix ne sont bien entendu donnés qu'à titre d'exemple.

Lorsque le registre d'état fonctionne en registre à décalage, son contenu sort de préférence vers un plot de sortie extérieur SCO connecté à la sortie de la dernière cellule RE4 du registre. Par cette sortie, on recueille la valeur des signaux stockés dans le registre d'état, en vue de les tester. Ces signaux sont soit les valeurs normales du registre d'état, (introduites à partir de la logique combinatoire LCB) soit les valeurs des signaux de contrôle en sortie de la logique GSC.

Dans l'exemple préférentiel représenté, étant donné qu'on cherche aussi à analyser des signaux contenus dans le registre d'instructions IR, on a prévu de connecter la sortie série ("scoir") du registre d'instructions IR à la deuxième entrée du premier multiplexeur MU1. On peut ainsi sortir par la borne SCO successivement les signaux stockés dans le registre d'état et les signaux stockés dans le registre IR.

Selon un mode de réalisation préféré de l'invention, on cherche en effet à tester, en utilisant le registre d'instructions IR, d'autres signaux qui sont les signaux destinés à commander la logique de décodage LDEC (cf. figure 1). Et ce test sera de préférence exécuté simultanément avec le test utilisant le registre d'état.

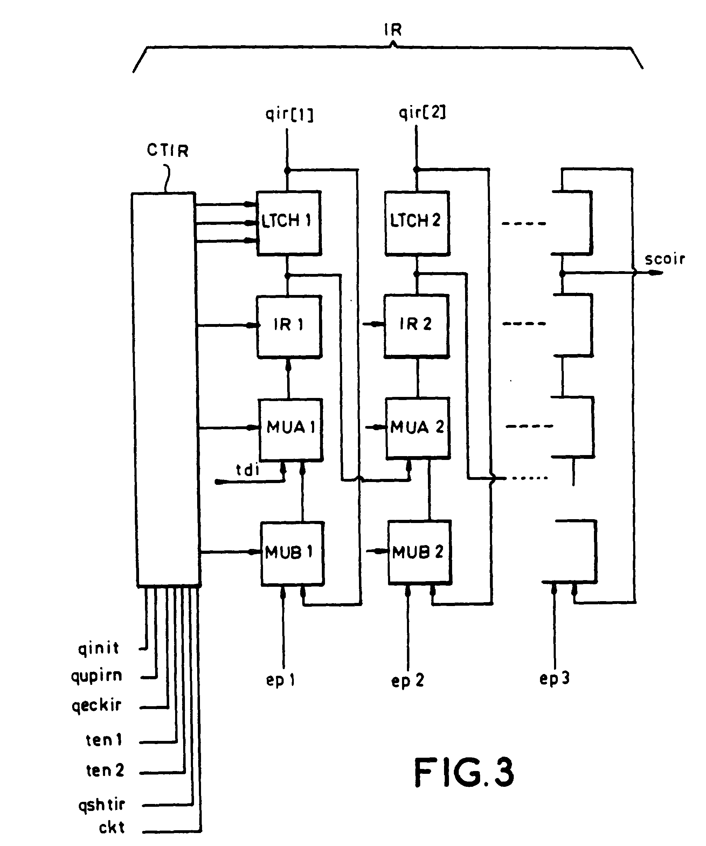

La figure 3 représente la circuiterie associée au registre d'instructions IR, modifiée en vue d'un test utilisant ce registre.

Le registre utilise n bascules binaires IR1, IR2, etc. Chaque bascule possède une entrée recevant un signal d'un multiplexeur élémentaire respectif MUA1, MUA2, etc., et une sortie connectée à une bascule de verrouillage respective LTCH1, LTCH2, etc., destinée à fournir des signaux verrouillés, qir[1], qir[2], etc. La combinaison de ces signaux représente une instruction en sortie du registre IR. Cette instruction est verrouillée, c'est-à-dire qu'elle ne change que lors de l'actionnement des bascules de verrouillage.

Les multiplexeurs MUA1, MUA2, permettent de sélectionner les signaux d'entrée appliqués aux bascules IR1, IR2, etc. du registre : pour un état du multiplexeur, les entrées sont appliquées en parallèle; pour un autre état le fonctionnement est celui d'un registre à décalage : la sortie d'une bascule est appliquée à l'entrée de la suivante, l'entrée de la première bascule IR1 est reliée à l'entrée TDI, la sortie de la dernière bascule est la sortie "scoir" visible à la figure 2.

Selon l'invention, un autre multiplexeur MUB1, MUB2, etc. respectivement est prévu en amont de chacun des multiplexeurs MUA1, MUA2, etc. Ces multiplexeurs permettent d'appliquer comme entrées parallèles du registre IR, soit des signaux ep1, ep2 etc. correspondant à une instruction qu'on peut charger en parallèle dans le registre, soit des signaux en provenance des sorties des bascules de verrouillage LTCH1, LTCH2, etc.; ce sont des signaux qu'on veut réintroduire dans le registre IR (d'où ils proviennent), uniquement à des fins de test.

A cet effet, les sorties des bascules de verrouillage sont rebouclées chacune sur une entrée de multiplexeur MUB1, MUB2 correspondante. Bien entendu, lorsqu'on mentionne l'existence d'un deuxième multiplexeur MUB1 en plus du multiplexeur MUA1, cela revient au même de dire que le multiplexeur MUA1 a un plus grand nombre d'entrées parallèles et de commandes de commutation correspondantes.

De même que certains autres registres du circuit de test, le registre IR comporte non seulement les bascules proprement dites constituant les cellules de stockage, mais aussi un circuit de contrôle associé CTIR qui commande les bascules et multiplexeurs du registre. Ce circuit de contrôle CTIR reçoit :
- l'horloge ckt;
- les signaux de contrôle issus du circuit GSC (figure 2) et relatifs au registre d'instructions : qinit, quplrn, qeckir, qshtir, pour le fonctionnement normal du registre
- les signaux de commande ten1 et ten2 pour le fonctionnement en test des multiplexeurs MUB1, MUB2 .. et des bascules IR1, IR2,... etc.

A partir de ces signaux, le registre CTIR élabore
- une commande de basculement des cellules IR1, IR2, .. etc. ;
- une commande de sélection d'une entrée des multiplexeurs MUA1, MUA2 , etc.;
- une commande de sélection d'une entrée des multiplexeurs MUA2, MUA3, etc.;
- une commande de changement d'état des bascules de verrouillage LTCH1, LTCH2, etc.;
- et éventuellement des commandes de basculement forcé ou remise à zéro forcée de ces bascules de verrouillage.

Dans cet exemple, la sortie série du registre d'instructions (sortie scoir) va vers l'entrée série du registre d'état (RE1 à RE4), de sorte que les contenus des registres se déversent successivement vers le plot de sortie SCO, mais ce n'est pas obligatoire : on pourrait envisager des opérations de test indépendantes à partir de chacun de ces deux registres.

Globalement, le test de la circuiterie de test se déroulera avant le test du circuit intégré proprement dit.

On peut examiner les contenus des registres d'état à un instant sélectionné (à l'aide des signaux ten1 et ten2); on peut examiner les sorties du générateur de signaux de contrôle GSC; et on peut examiner les sorties verrouillées du registre d'instructions.

Et les résultats de ces examens sortent en cascade par la sortie SCO. Le tout est fait sous contrôle des signaux ten1 et ten2 à des instants désirés d'un cycle de fonctionnement de la machine à états finis et pour des instructions désirées préalablement chargées dans le registre d'instructions.

## Revendications

1. Circuit intégré qui comprend une circuiterie nécessaire au test du circuit, avec un contrôleur (TAPC) comportant :
- une machine à états finis comportant un registre d'états (RE1 à RE4) ayant des sorties parallèles ;
- des multiplexeurs (MU1 à MU4) associés aux cellules du registre d'états pour permettre soit un fonctionnement sériel soit un fonctionnement parallèle de ce registre d'états;
- et un étage de génération de signaux de contrôle (GSC), connecté aux sorties parallèles du registre pour fournir des signaux de contrôle d'autres éléments de la circuiterie de test, en fonction de l'état défini par le registre d'états,
caractérisé en ce que les multiplexeurs associés aux cellules du registre d'états sont pourvus d'entrées spécifiques permettant de stocker dans ces cellules, en vue de les transmettre ultérieurement pour observation, l'état d'au moins certains des signaux de contrôle.

2. Circuit intégré selon la revendication 1, caractérisé en ce que les multiplexeurs sont commandés par des signaux (ten1, ten2) issus de l'extérieur du circuit Intégré.

3. Circuit intégré selon la revendication 1, caractérisé en ce que le registre d'états, lorsqu'il fonctionne en registre à décalage, possède une sortie reliée à une borne extérieure spécifique (SCO) du circuit intégré, différente des bornes par lesquelles peuvent sortir les signaux de test autres que ceux des signaux de contrôle.

4. Circuit intégré selon la revendication 1, dans lequel la circuiterie de test comprend un registre d'instructions (IR) suivi d'une logique (LDEC) de décodage des instructions contenues dans le registre, le registre étant associé à des multiplexeurs d'entrée permettant de faire fonctionner le registre à volonté en série ou en parallèle, caractérisé en ce que les multiplexeurs comportent des entrées supplémentaires permettant de stocker dans le registre des signaux logiques prélevés sur les sorties verrouillées du registre d'instructions.

## Patentansprüche

1. Integrierte Schaltung, die eine für die Prüfung der Schaltung erforderliche Schaltungsanordnung mit einer Steuereinrichtung (TAPC) umfaßt, wobei die Steuereinrichtung (TAPC) enthält:
- eine Maschine mit endlich vielen Zuständen, die ein Zustandsregister (RE1 bis RE4) mit parallelen Ausgängen enthält;
- Multiplexierer (MU1 bis MU4), die den Zellen des Zustandsregisters zugeordnet sind, um entweder einen seriellen Betrieb oder einen parallelen Betrieb dieses Zustandsregisters zu ermöglichen;
- und eine Steuersignal-Erzeugungsstufe (GSC), die an die parallelen Ausgänge des Registers angeschlossen ist, um in Abhängigkeit von dem durch das Zustandsregister definierten Zustand Steuersignale für andere Elemente der Prüfschaltungsanordnung zu liefern,
dadurch gekennzeichnet, daß die den Zellen des Zustandsregisters zugeordneten Multiplexierer mit spezifischen Eingängen versehen sind, die ermöglichen, den Zustand wenigstens bestimmter der Steuersignale in diesen Zellen zu speichern, um sie schließlich für die Beobachtung zu übertragen.

2. Integrierte Schaltung nach Anspruch 1, dadurch gekennzeichnet, daß die Multiplexierer durch Signale (tenl, ten2) gesteuert werden, die von außerhalb der integrierten Schaltung ankommen.

3. Integrierte Schaltung nach Anspruch 1, dadurch gekennzeichnet, daß das Zustandsregister dann, wenn es als Schieberegister arbeitet, einen Ausgang besitzt, der mit einem spezifischen äußeren Anschluß (SCO) der integrierten Schaltung verbunden ist, der von den Anschlüssen verschieden ist, über die die Prüfsignale ausgegeben werden können, die von den Steuersignalen verschieden sind.

4. Integrierte Schaltung nach Anspruch 1, in der die Prüfschaltungsanordnung ein Befehlsregister (IR), gefolgt von einer Decodierungslogik (LDEC) für die im Register enthaltene Befehle umfaßt, wobei das Register Eingangsmultiplexierern zugeordnet ist, die ermöglichen, das Register nach Belieben seriell oder parallel zu betreiben, dadurch gekennzeichnet, daß die Multiplexierer zusätzliche Eingänge aufweisen, die ermöglichen, im Register Logiksignale zu speichern, die an den gesperrten Ausgängen des Befehlsregisters abgegriffen werden.

## Claims

1. Integrated circuit which comprises circuitry necessary for testing the circuit, with a controller (TAPC) including:
- a finite-state machine including a state register (RE1 to RE4) having parallel outputs;
- multiplexers (MU1 to MU4) associated with the cells of the state register to allow either serial operation or parallel operation of this state register;
- and a control signal generation stage (GSC), connected to the parallel outputs of the register, in order to supply control signals for other elements of the test circuitry, depending on the state defined by the state register, characterized in that the multiplexers associated with the cells of the state register are provided with specific inputs making it possible to store the state of at least some of the control signals in these cells, with a view to sending them subsequently for observation.

2. Integrated circuit according to Claim 1, characterized in that the multiplexers are controlled by signals (ten1, ten2) coming from outside the integrated circuit.

3. Integrated circuit according to Claim 1, characterized in that the state register, when it operates in shift-register mode, has an output linked to a specific external terminal (SCO) of the integrated circuit, different from the terminals by which the test signals other than those of the control signals can exit.

4. Integrated circuit according to Claim 1, in which the test circuitry comprises an instruction register (IR) followed by logic (LDEC) for decoding the instructions contained in the register, the register being associated with input multiplexers making it possible to make the register operate in serial or in parallel mode at will, characterized in that the multiplexers comprise additional inputs making it possible to store, in the register, logic signals picked up on the latched outputs of the instruction register.
